Europäisches Patentamt

European Patent Office

Office européen des brevets

(11) Veröffentlichungsnummer: **0 460 287 A1**

## (12) EUROPÄISCHE PATENTANMELDUNG

(21) Anmeldenummer: 90123460.9

(22) Anmeldetag: 06.12.90

(51) Int. Cl.5: **H01L 31/062**, H01L 31/032, H01L 31/0224, H01L 31/0216

(30) Priorität: 31.05.90 DE 4017590

(43) Veröffentlichungstag der Anmeldung:
**11.12.91 Patentblatt 91/50**

(84) Benannte Vertragsstaaten:
**DE FR GB IT**

(71) Anmelder: **SIEMENS AKTIENGESELLSCHAFT**
**Wittelsbacherplatz 2**
**W-8000 München 2(DE)**

(72) Erfinder: **Krühler, Wolfgang, Dr. rer. nat.**
**Ludwig-Thoma-Strasse 80**
**W-8025 Unterhaching(DE)**
Erfinder: **Grabmaier, Josef, Dr. rer. nat.**
**Am Seefeld 17**
**W-8137 Berg 1(DE)**

(54) **Neuartige Chalkopyrit-Solarzelle.**

(57) Es wird eine neuartige Solarzelle aus I-III-VI$_2$-Halbleitermaterialvorgeschlagen, welche eine Inversionsschicht aufweist. Aufgebaut wird die Zelle aus einem Substrat mit einer elektrisch leitenden ersten Elektrode, einer p-leitenden polykristallinen Halbleiterschicht aus Chalkopyrit-Material, einer Barriereschicht aus einem elektrisch nicht leitenden Material, einer Antireflexschicht und einer zweiten Elektrode, wobei die Antireflexschicht ortsfeste positive Ladungen aufweist, welche im Grenzflächenbereich der Halbleiterschicht zur Barriereschicht eine negativ geladene Inversionsschicht induzieren, welche als Emitter für eine Raumladungszone dient. Eine bevorzugte Ausführungsform weist eine Halbleiterschicht aus Kupfer-Indium-Diselenid oder Kupfer-Gallium-Diselenid, eine Barziereschicht aus Siliziumdioxid, eine Antireflexschicht aus Siliziumnitrid und als ortsfeste Ladungen Cäsiumchlorid auf.

EP 0 460 287 A1

Rank Xerox (UK) Business Services

Solarzellen und photovoltaische Solarmodule zur elektrischen Leistungserzeugung müssen heute kostengünstig sein und Wirkungsgrade von mindestens 15 Prozent aufweisen, um mit konventionellen Energieerzeugern in Konkurrenz treten zu können. Obwohl Solarzellen aus kristallinem Silizium hohe Wirkungsgrade aufweisen, ist man doch bestrebt, zur Material- und Kostenersparnis zu den kostengünstigeren Dünnschichtsolarzellen aus amorphem oder polykristallinen Halbleitern überzugehen. Während Solarzellen aus amorphen Halbleitermaterialien noch im Wirkungsgrad und in der Langzeitstabilität zu verbessern sind, werden mit Dünnschichtsolarzellen aus polykristallinen Halbleitern bereits gute Ergebnisse erzielt.

Gegenstand jüngster Forschungen sind Solarzellen aus polykristallinem Chalkopyrit-Material. Bekanntester Vertreter dieser Klasse ist Kupfer-Indium-Diselenid (CIS), welches ein direkter Halbleiter mit einem Bandabstand von 1,0 eV ist. Aus der Lage der Bandlücke läßt sich ein theoretischer maximaler Wirkungsgrad von ca. 25 Prozent erwarten, wobei mit bereits hergestellten kleinflächigen Testzellen Wirkungsgrade von nahezu 15 Prozent erreicht wurden.

Eine zum Beispiel durch einen Artikel von K. Mitchell et al in IEEE 1988, Seite 1384 bis 1389 bekannte CIS-Solarzelle besteht aus einem mit Molybdän als Rückseitenelektrode beschichtetem Glassubstrat, einer polykristallinen p-leitenden CIS-Halbleiterschicht als Absorber, einer dünnen n-leitenden Cadmiumsulfidschicht als Elektronenemitter, einer Zinkoxidschicht als transparente Elektrode und einem Aluminiumgrid zur Ableitung des erzeugten Stromes.

Das größte Problem bei der Herstellung von CIS-Solarzellen ist die Anpassung der verschiedenen Kristallgitter bzw. der Übergang zwischen Absorber und Emitterschicht. Die unterschiedlichen Gitter dürfen maximal 1 Prozent differieren, um noch einen tolerierbaren Wirkungsgrad zu erreichen. Höhere Unterschiede haben eine erhöhte Anzahl von Defekten in der Bandlücke zur Folge, welche wiederum Rekombinationstellen für Ladungsträger darstellen und die elektrische Leistung einer solchen Solarzelle vermindern. Außerdem muß im Bereich des pn-Übergangs die Stöchiometrie des CIS-Materials verändert werden, um eine "$p^{+}$-Dotierung" zu erreichen.

Neben weiteren Problemen bei der Herstellung einer homogenen Halbleiterschicht, welche aus drei Komponenten besteht, ist vor allem die Verwendung des giftigen Cadmiums für die Emitterschicht aus Umweltschutzgründen von Nachteil.

Aufgabe der vorliegenden Erfindung ist es daher, eine Chalkopyrit-Solarzelle mit hohem Wirkungsgrad anzugeben, welche Probleme mit der Gitteranpassung der verwendeten Halbleitermaterialien vermeidet und außerdem auf die Verwendung von Cadmiumsulfid verzichtet.

Diese Aufgabe wird erfindungsgemäß gelöst durch eine Solarzelle mit Schichtaufbau, welche nachfolgend übereinander aufweist

- ein Substrat mit einer elektrisch leitenden ersten Elektrode,
- eine p-leitende polykristalline Halbleiterschicht aus einem I-III-VI$_2$-Chalkopyrit-Material,
- eine Barriereschicht aus einem elektrisch nicht leitenden Material,
- eine Antireflexschicht und
- eine zweite Elektrode zur Ableitung des erzeugten Stromes,

wobei die Antireflexschicht zumindest an der Grenzfläche zur Barriereschicht ortsfeste positive Ladungen aufweist, welche im Grenzflächenbereich der Halbleiterschicht zur Barriereschicht eine negativ geladene Inversionsschicht induzieren, die als Emitter für eine Raumladungszone dient.

Weitere Ausgestaltungen der Erfindung sind den Unteransprüchen zu entnehmen.

Diese erfindungsgemäße Solarzelle nutzt das Prinzip der bei Solarzellen aus kristallinem Silizium bekannten MIS-Inversionsschichtsolarzelle, welches zum Beispiel einem Artikel von R. Hezel in Status Report 1990, Photovoltaic, 2. bis 4. Mai 1990, Seite 15-1 bis 15-15 zu entnehmen ist. Während herkömmliche kristalline Solarzellen wie Halbleiter-Dioden mit metallurgischem pn-Übergang arbeiten, besitzt die MIS-Inversionsschichtsolarzelle einen induzierten pn-Übergang, analog einem MOS (Metall-Oxid-Silizium)-Transistor. Die MIS-Inversionsschichtsolarzelle hat einen Körper aus kristallinem p-dotiertem Silizium als Absorber, eine dünne Isolierschicht aus Siliziumoxid und eine Deckschicht aus Siliziumnitrid. An der Grenzfläche zur Siliziumoxidschicht ist die Siliziumnitridschicht mit positiven Ladungsträgern, beispielsweise mit schweren Alkaliionen angereichert, welche im Grenzflächenbereich der Siliziumschicht jenseits der Siliziumdioxidschicht eine negative Grenzflächenaufladung induzieren. Diese Anreicherung von Elektronen im eigentlich p-leitenden Halbleitermaterial wird Inversionsschicht genannt. Diese Schicht kann wie eine normale n-leitende Schicht als Emitter für eine an Ladungsträgern verarmte Raumladungszone im p-Halbleiter dienen, wobei sich ein elektrisches Feld entsprechend dem Ladungszustand der entsprechenden Halbleiterschichten aufbaut. In diesem werden die Ladungsträger getrennt und erzeugen so an den anliegenden elektrischen Kontakten einen elektrischen Strom.

Die Erfindung nutzt dieses Prinzip und stellt damit eine CIS-Solarzelle zur Verfügung, die keinen pn-Übergang erfordert und so das Problem der Gitteranpassung zwischen Halbleiterschicht und Emitterschicht vermeidet. Auf der homogen und defektarm herzustellenden Halbleiterschicht aus Chalkopyrit-Material kann direkt eine beliebige Barriereschicht aus einem elektrisch isolierenden Material erzeugt werden. In einfacher Weise wird die Barriereschicht daher beispielsweise aus einem isolierenden amorphen Oxid dargestellt. Aufgrund dessen amorpher Struktur ist keine Gitteranpassung erforderlich. Über der Barriereschicht befindet sich die Antireflexschicht. Diese dient zum einen als Fensterschicht für die einfallende Sonnenstrahlung und stellt außerdem die Matrix für die ortsfesten positiven Ladungen dar. Neben einem hohen optischen Bandabstand, um die Transparenz zu gewährleisten, weist die Antireflexschicht daher entsprechende Matrixeigenschaften auf und muß die vorzugsweise für die ortsfesten positiven Ladungen verwendeten Metallsalze sicher in ihre Struktur einbinden.

Die zweite Elektrode kann direkt auf der Barriereschicht sitzen, um die im Bereich der ortsfesten positiven Ladungen sich bewegenden Minoritätsladungsträger (Elektronen) besser ableiten zu können. Dazu ist die zweite Elektrode vorteilhafterweise möglichst feinmaschig strukturiert und weist beispielsweise einen Leiterbahnabstand von ca. 200 bis 300 $\mu$m und einen Leiterbahndurchmesser von ca. 20 bis 30 $\mu$m auf.

Die Halbleiterschicht besteht zum Beispiel aus Kupfer-Indium-Diselenid, wobei unabhängig voneinander Indium durch Gallium und Selen durch Schwefel ersetzt sein kann. Die Verwendung von Gallium anstelle von Indium hat gegenüber dem besser erforschten CIS-Material den Vorteil, daß die dafür nötigen Rohstoffe länger und in ausreichender Menge verfügbar sind. Der Ersatz von Selen durch Schwefel kann ohne größere Leistungseinbußen weitere Vorteile in der Umweltverträglichkeit der Solarzelle bzw. des zur Herstellung verwendeten Verfahrens erbringen.

Die Dicke der Halbleiterschicht wird so gewählt, daß das einfallende Licht vollständig absorbiert wird, wozu eine Schichtstärke von ca. 1 bis 2 $\mu$m ausreichend ist.

Die Barriereschicht hat eine Dicke von weniger als 5 nm und wird so dünn wie möglich gefertigt. Das dafür gut geeignete amorphe Siliziumoxid $SiO_x$ (x kleiner 2) läßt sich mit heutigen Verfahren gut in einer Schichtdicke von maximal 2 nm homogen abscheiden, beispielsweise durch eine Niederdruckglimmentladung in einer Silan ($SiH_4$) und Sauerstoff enthaltenden Atmosphäre. Doch sind grundsätzlich auch andere elektrisch isolierende Materialien geeignet, sofern sie sich homogen, amorph und entsprechend dünn erzeugen lassen.

Direkt auf der Barriereschicht wird die zweite Elektrode aufgebracht, beispielsweise durch Aufdampfen eines dünnen und engmaschigen metallischen Gitters (zum Beispiel aus Aluminium) durch eine entsprechende Maske.

Darüber, vor allem im Bereich der zwischen den Leiterbahnen des Elektrodengitters freiliegenden Oberfläche der Barriereschicht werden nun die ortsfesten Ladungen aufgebracht. Die Beschichtung kann durch Ansprühen oder Spin-on-Technik erfolgen, wozu insbesondere ein Alkalihalogenid, vorzugsweise. Cäsiumchlorid verwendet wird.

Direkt auf dieser wenige Atomlagen dicken Schicht wird die Antireflexschicht erzeugt. Diese ist ebenfalls amorph und wird vorteilhafterweise im gleichen Glimmentladungsreaktor erzeugt, beispielsweise durch Zersetzen von Silan und Ammoniak, wobei eine ca. 100 nm dicke Silizium-nitridschicht ($Si_3N_4$) erzeugt wird. Während der Beschichtung diffundieren die Cäsiumionen wenige Angström tief in die Siliziumnitridschicht ein, wo sie fixiert werden.

Die positiven ortsfesten Raumladungen der Siliziumnitrid/Cäsiumschicht induzieren über die dünne Barriereschicht (Tunneloxid) negative Ladungen im oberen Bereich der Halbleiterschicht. Diese Elektronenanreicherung bedeutet in diesem ca. 30 nm dicken Bereich eine Inversion der ursprünglichen p-Leitung in eine n-Leitung. Die Inversionsschicht kann daher die Funktion des n-Emitters zur Erzeugung einer Raumladungszone (RLZ) in der Halbleiterschicht übernehmen.

Als Substrat kann ein beliebiges Material dienen, welches bei nicht ausreichender elektrischer Leitfähigkeit mit der ersten Elektrode beschichtet ist. Als preisgünstige Lösung wird dazu vorteilhafterweise eine mit Molybdän beschichtete Glasplatte verwendet. Diese Anordnung weist keine Probleme bezüglich der Haftfestigkeit der Halbleiterschicht auf der ersten Elektrode bzw. der Elektrode auf dem Glas auf, was für andere Substrat/Elektroden-Kombinationen nicht unbedingt gilt.

Im folgenden wird die Erfindung anhand eines Ausführungsbeispiels und der dazugehörigen Figur näher erläutert.

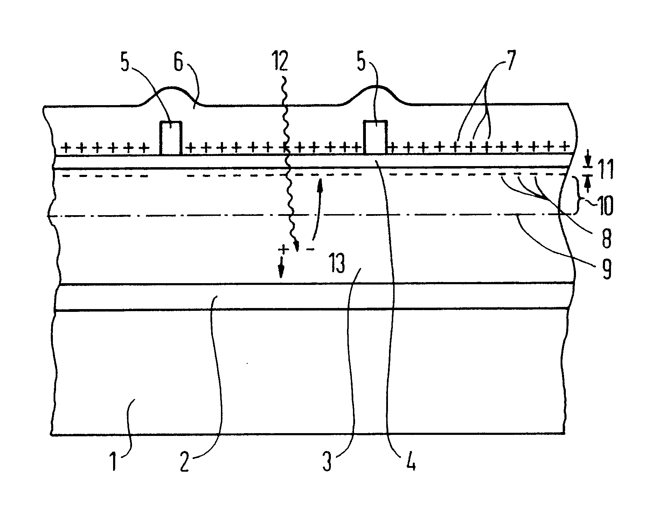

Die Figur zeigt im schematischen Querschnitt eine erfindungsgemäße Solarzelle. Zur klareren Darstellung sind die wirklichen Größenverhältnisse nicht maßstabsgetreu wiedergegeben.

Als Substrat 1 dient eine 1 mm dicke Glasplatte, auf der eine 2 $\mu$m starke Molybdänschicht 2 als erste Elektrode aufgebracht wird. Als Halbleiterschicht 3 wird darauf eine polykristalline p-leitende CIS-Schicht nach bekannten Verfahren aufgebracht, beispielsweise durch gleichzeitiges Verdampfen von Kupfer, Indium und Selen aus getrennten Tiegeln. Doch auch andere, bekannte Verfahren sind möglich, zum Beispiel Herstellen der CIS-Halbleiterschicht 3 durch Electroplating, pyrolytische Abscheidung, Aufdampfen oder Sputtern von Kupfer- und Indiumschichten in Folge und anschließendes

Selenisieren in einer H$_2$Se-Atmosphäre oder auch durch Aufdampfen von Kupfer-, Indium- und Selenschichten in Folge und anschließendes Tempern.

Über der Halbleiterschicht 3 wird in einem Niedertemperatur-Glimmentladungs-Prozeß, in dem Silan (SiH$_4$) und Sauerstoff zersetzt werden, eine ca. 2 nm dicke amorphe SiO$_x$-Schicht 4 abgeschieden (x $\leq$ 2). Durch Aufdampfen von Aluminium durch eine entsprechende Maske wird ein dünnes und engmaschiges Grid 5 als zweite Elektrode auf der Barriereschicht 4 aufgebracht. Durchmesser und Abstände der einzelnen Leiterbahnen des Grids 5 werden dabei möglichst klein gewählt, beispielsweise 20 $\mu$m breite Leiterbahnen in einem Abstand von 200 $\mu$m.

Auf dieser Oberfläche (4, 5) werden nun ortsfeste positive Ladungen (Cäsiumionen) durch Aufsprühen von Cäsiumchlorid in einer dünnen Schicht von mehreren Molekülagen aufgebracht. In einem weiteren Glimmentladungsprozeß wird darüber durch Zersetzen von Silan und Ammoniak eine ca. 100 nm dicke Siliziumnitridschicht (Si$_3$N$_4$) erzeugt, die als Antireflexschicht 6 dient. Während dieser Beschichtung diffundieren die Cäsiumionen wenige Angström tief in die Siliziumnitridschicht ein, wo sie fixiert werden. In der Figur sind diese positiven Ladungen durch Pluszeichen dargestellt und mit Bezugszeichen 7 versehen. Jenseits der Barriereschicht 4 erzeugen diese positiven Ladungen 7 nun die entsprechenden negativen Ladungen 8 im obersten Schichtbereich 11 der Halbleiterschicht 3. Diese negativen Ladungen 8 in der ursprünglich p-leitenden Halbleiterschicht 3 bilden die Inversionsschicht 11, welche als Emitter zum Aufbau einer Raumladungszone 10 dient. Diese entsteht unterhalb der Inversionsschicht 11 und reicht beispielsweise bis zur mit Bezugszeichen 9 bezeichneten gestrichelten Linie.

Zum Betrieb der erfindungsgemäßen Solarzelle wird durch die Antireflexschicht 6 bestrahlt. Deren Material (Siliziumnitrid) ist ebenso wie das Siliziumdioxid der Barriereschicht 4 aufgrund des hohen Bandabstandes für Sonnenlicht transparent. Ein einfallendes Lichtquant 12 wird daher erst in der Halbleiterschicht 3 absorbiert und erzeugt dort ein Ladungsträgerpaar 13. Im Feld der Raumdladungszone 10, welches dem an der Barriereschicht 4 anliegenden Feld entspricht, werden die Ladungsträger 13 getrennt und schließlich an den Elektroden 2 bzw. 5 abgeführt. Die dünne Barriereschicht 11 kann dabei von den Elektronen durchtunnelt werden.

In der Figur nicht dargestellt ist ein "normales" weiteres Grid auf der Oberfläche der Antireflexschicht 6 zur Ableitung des zunächst im Grid 5 gesammelten Stromes. Ebenfalls nicht dargestellt ist die elektrische Verschaltung der erfindungsgemäßen Solarzelle zu einem Modul, welche nach einem der für Dünnschichtsolarzellen bekannten Verfahren erfolgen kann.

Insgesamt hat das im Ausführungsbeispiel angegebene Herstellungsverfahren den Vorteil, daß alle Schritte im Niedertemperaturbereich $\leq$ 500 $^\circ$C durchgeführt werden können.

Das Inversionsprinzip der in diesem Ausführungsbeispiel beschriebenen CIS-Solarzelle ist auch analog auf andere Chalkopyrit-Solarzellen aus CuIn (Ga) Se$_2$ (S$_2$) anwendbar.

**Patentansprüche**

1. Solarzelle mit Schichtaufbau, nachfolgend übereinander aufweisend
   - ein Substrat mit einer elektrisch leitenden ersten Elektrode,
   - eine p-leitende polykristalline Halbleiterschicht aus einem I-III-VI$_2$ Chalkopyrit-Material,
   - eine Barriereschicht aus einem elektrisch nicht leitenden Material,
   - eine Antireflexschicht und
   - eine zweite Elektrode zur Ableitung des erzeugten Stroms,

   wobei die Antireflexschicht zumindest an der Grenzfläche zur Barriereschicht ortsfeste positive Ladungen aufweist, welche im Grenzflächenbereich der Halbleiterschicht zur Barriereschicht eine negativ geladene Inversionsschicht induzieren, die als Emitter für eine Raumladungszone dient.

2. Solarzelle nach Anspruch 1, **dadurch gekennzeichnet,** daß die Halbleiterschicht eine Kupfer-Indium-Diselenid-Schicht ist, wobei unabhängig voneinander Indium durch Gallium und Selen durch Schwefel ersetzt sein kann.

3. Solarzelle nach Anspruch 1 oder 2, **dadurch gekennzeichnet,** daß die Barriereschicht aus amorphem Siliziumoxid besteht und eine Dicke von kleiner 5 nm aufweist.

4. Solarzelle nach einem der Ansprüche 1 bis 3, **dadurch gekennzeichnet,** daß die Antireflexschicht eine Siliziumnitridschicht ist.

5. Solarzelle nach Anspruch 4, **dadurch gekennzeichnet,** daß die Antireflexschicht ein aus Silan (SiH$_4$) und Ammoniak abgeschiedenes Plasmanitrid ist.

6. Solarzelle nach mindestens einem der Ansprüche 1 bis 5, **dadurch gekennzeichnet,** daß die zweite Elektrode ein engmaschiges metallisches Grid, vorzugsweise aus Aluminium, ist.

7. Solarzelle nach mindestens einem der Ansprüche 1 bis 6, **dadurch gekennzeichnet,** daß die ortsfesten positiven Ladungen durch mehrere Moleküllagen eines höheren ionischen Alkalihalogenids gebildet werden.

8. Solarzelle nach Anspruch 7, **dadurch gekennzeichnet,** daß das Alkalihalogenid Cäsiumchlorid ist.

9. Solarzelle mit nachfolgendem Schichtaufbau aus
   - einem Molybdän-beschichteten Glassubstrat,
   - einer 1 bis 2 μm dicken polykristallinen Schicht aus I-III-VI$_2$-Chalkopyrit-Material,
   - einer Barriereschicht aus einem in maximal 2 nm Dicke abgeschiedenen amorphen Siliziumdioxid,
   - einem engmaschigen Aluminiumgrid auf der Barriereschicht und
   - darüber aufgebrachtem 50 bis 200 nm dickem amorphen Siliziumnitrid, welches zumindest an der Grenzfläche zur Barriereschicht mehrere Moleküllagen Cäsiumchlorid enthält.

**Europäisches Patentamt**

# EUROPÄISCHER RECHERCHENBERICHT

Nummer der Anmeldung

**EP 90 12 3460**

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (Int. Cl.5) |
|---|---|---|---|
| A | SIXTEENTH IEEE PHOTOVOLTAIC SPECIALISTS CONFERENCE, San Diego, CA, 27. - 30. September 1982, Seiten 1237-1242, IEEE, New York, US; R. HEZEL: "High charge densities in Si-nitride and their effect of the inversion layer mobility of silicon MIS/IL solar cells" * Seite 1237; Seite 1238, Abschnitt betitelt: "Experimental"; Abbildung 1 * | 1,3-9 | H 01 L 31/062<br>H 01 L 31/032<br>H 01 L 31/0224<br>H 01 L 31/0216 |
| A | GB-A-2 034 973 (R. HEZEL) * Insgesamt * | 1,3-7,9 | |
| A | DE-A-3 831 857 (M. KNOLL) * Insgesamt * | 1,3,4,6-9 | |
| A | EP-A-0 318 315 (ATLANTIC RICHFIELD CO.) * Spalte 2, Zeile 55 - Spalte 3, Zeile 22; Abbildung 1 * | 1,2,6,9 | |
| A | NINETEENTH IEEE PHOTOVOLTAIC SPECIALISTS CONFERENCE, New Orleans, Louisana, 4. - 8. Mai 1987, Seiten 1279-1284, IEEE, New York, US; R. SINGH et al.: "Rapid isothermal processing of bulk and thin film solar cells" * Insgesamt * | 1,2,6,9 | |

| RECHERCHIERTE SACHGEBIETE (Int. Cl.5) |
|---|
| H 01 L |

Der vorliegende Recherchenbericht wurde für alle Patentansprüche erstellt

| Recherchenort | Abschlußdatum der Recherche | Prüfer |
|---|---|---|
| Den Haag | 04 September 91 | DE LAERE A.L.C. |